(19) Europäisches Patentamt
European Patent Office
Office européen des brevets

(11) **EP 4 517 302 A1**

(12) **EUROPEAN PATENT APPLICATION**

(43) Date of publication:
**05.03.2025 Bulletin 2025/10**

(21) Application number: **23193638.6**

(22) Date of filing: **28.08.2023**

(51) International Patent Classification (IPC):
**G01N 21/39** (2006.01)    **G01N 21/552** (2014.01)
**G01N 21/3504** (2014.01)   **G01N 21/3577** (2014.01)
**H01S 5/30** (2006.01)

(52) Cooperative Patent Classification (CPC):
**G01N 21/553; H01S 5/30**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Valstybinis moksliniu tyrimu institutas
Fiziniu ir
technologijos mokslu centras
10257 Vilnius (LT)**

(72) Inventors:
• **Vaicikauskas, Viktoras**
  **Vilnius (LT)**
• **Devenson, Jan**
  **Vilnius (LT)**
• **Setkus, Arunas**
  **Vilnius (LT)**
• **Nargeliene, Viktorija**
  **Vilnius (LT)**

(74) Representative: **Pakeniene, Ausra**
  **AAA Law
  A. Gostauto street 40B
  03163 Vilnius (LT)**

(54) **A VOLATILE MOLECULAR COMPONENTS DETECTION DEVICE**

(57) The present invention is a semiconductor infrared light emitting element-based device for detection and identification of volatile chemical molecular compounds. The device detects volatile molecules, particularly trace amounts of gaseous compounds in air samples, by measuring the chemical interaction-dependent propagation of surface plasmonic waves. The device comprises a quantum cascade light emitter (3) with an electrode (2) and an anti-reflective structure (4), as well as external cavity-mounted components including a flat plate optical filter (6), rotational disk (7), and spherical mirror (8) for scanning wavelengths across a wide spectral range. The plasmonic waveguide (9), coupled to the first semi-reflective facet (5), translates the interaction between molecules and the surface into changes in optical parameters that are subsequently detected by a coupled photonic detector (10).

Fig. 1

**Description**

TECHNICAL FIELD

The invention relates to a mid-infrared semiconductor laser device for detecting volatile molecules, specifically trace amounts of gaseous compounds in air samples, by measuring propagation of surface plasmonic waves dependent on chemical interactions. In particular, the invention relates to a system for identifying volatile molecular compounds in gaseous mixtures through spectroscopic analysis, utilizing tuneable laser emission in the mid-infrared region.

BACKGROUND ART

Detecting and identifying chemical molecules by examining their optical characteristics related to specific chemical bond energies is a well-established method. Integrating elements of an optical setup into compact systems has proven advantageous for lab-on-chip devices, particularly when testing liquid analytes. However, these approaches are limited by losses and weak control of broadband incandescent lamps or extremely narrow bands of semiconductor lasers as infrared light sources.

A narrowband semiconductor laser-based chemical compound detector comprising a quantum cascade laser (QCL) and a similarly structured light detector (QCD) connected through a surface plasmon polariton waveguide on the same substrate is disclosed in *B. Schwarz et al. Applied Physics Letters 106, 041101 (2015)*. According to the publication changes in the narrowband light emitted by the QCL and subsequently detected by the QCD serve as measures for the presence of target chemical compounds interacting with the waveguide surface in the gap between the QCL and QCD.

Known designs of compact semiconductor detection and recognition systems are limited to a very narrow wavelength line of laser-emitted infrared light, making it difficult to extend the application of the system to volatile molecular compounds, such as volatile organic compounds and polymer nanoparticles. Known spectroscopic systems using laser wavelength tuning focus on the analysis of optical absorption-based methods.

US patent No. US11,075,315 discloses an optical semiconductor element comprising a semiconductor substrate, a first laminated structure provided on a front surface of the semiconductor substrate, and a second laminated structure provided on the front surface of the semiconductor substrate, the first laminated structure includes a first quantum cascade region, the second laminated structure includes a dummy region having the same layer structure as the first quantum cascade region, a second quantum cascade region provided on the front surface of the semiconductor substrate via the dummy region, and one of the first quantum cascade region and the second quantum cascade region is a quantum cascade laser, and the other of the first quantum cascade region and the second quantum cascade region is a quantum cascade detector. The integrated semiconductor element comprises a QCL and QCD of the same layer arrangement on the same substrate. Significant limitation for gas amount detection exists in this integrated semiconductor element due to low volume of the dummy region filled by gas that determines the changes in the optical absorption of the QCL emitted light and, consequently, in the QSD produced output signal.

Spectroscopic band expansion is achievable due to fundamental mechanisms that make the wavelength of the emitted light dependent on path modifications between the mirrors during laser emission amplification, which is released through the laser's front facet.

US patent No. US6,970,484 discloses a tuneable laser and laser tuning method, based on the interaction of a spectrally dependent beam distortion and a spatial filter within a laser cavity. One embodiment of this laser is an external cavity semiconductor laser in which broad tunability is obtained by the insertion of an acousto-optic tuneable filter (AOTF) into the laser cavity such that the intra-cavity laser beam passes through the AOTF in zeroth order. Since the mixing of three waves requires generation of acoustic waves in the AOTF tuning of the wave lengths is specifically related to the limited variety of the functional crystals that complicates development of gas detecting systems.

US patent No. US7,733,924 discloses a mode-hop-free mid-infrared QCL chip by combining means for controlling the QCL external cavity length and the grating angle of the diffraction grating with respect to the chip. Additional construction comprising a mirror is used for the output beam guiding in the chip significantly enlarging the compartment of the device.

US patent No. US8,351,474 discloses a compact laser system for nearly continuous wavelength scanning by changing the incident light angle using a mirror or grating rotatable around a pivot axis in an external cavity. The rotatable grating provides fast and large sweeping of the wave lengths but combines the same external cavity arrangement for amplification of the emitted light and output of the laser beam that makes the output power less controllable.

US patent No. US6,556,599 discloses a system for tuning a wavelength over entire emission range in an external cavity semiconductor laser comprising a retroreflector scheme with an angle-tune filter relative to the optical axis. Though proposed system provides semiconductor light source with sufficiently wide tuneable range of the wave lengths it requires technological and constructional changes aiming to fuse the functionality of the light emission with the light-gas interaction and the detection of the optical response to that interaction.

US patent No. US10,348,053 discloses a tuneable laser with an optical gain region implemented using one or more thermo-optically tuneable filters in an external cavity. An example of tuning of the wave lengths of a quantum cascade laser uses a thermally controlled unit that creates request for improved thermal isolation in the system with the working temperature adjustable infrared light emitter.

The proposed invention addresses the problem of applying spectroscopic analysis to surface plasmon principles-based detection and identification of molecular compounds mixed with air.

BRIEF DESCRIPTION OF THE INVENTION

The present invention discloses a compact semiconductor system and method for integrating functional components into such system.

The system according to the invention comprises a quantum cascade laser with a spectroscopically acceptable variation of emitted infrared light wavelength, a surface plasmon waveguide open for surface chemical interaction, and a photonic detector.

The semiconductor infrared light source of the quantum cascade laser comprises a semiconductor substrate made of the same material used for quantum cascade laser growth. The substrate's bottom surface includes a bottom electrical contact and metallic electrode for connection to an electrical power supply terminal. The top surface contains two areas with individual functional elements: the infrared light source and the surface plasmon guide. This configuration addresses the integration of the light source and plasmon waveguide on a single semiconductor substrate and optimizes coupling between them.

The light source features an epitaxially grown structure with an individual arrangement depending on its functional use. It consists of a quantum cascade laser (QCL) structure optimized for an infrared wavelength range of approximately 5 to 12 micrometres, with a specially formed facet for the front edge. An anti-reflection layer covers the QCL light source's rear facet, enabling the use of an external cavity wavelength variation mechanism.

The surface plasmon waveguide is a multilayer structure formed on a part of the QCL light source substrate, made clear by clean removal of the QCL arrangement. The waveguide is a rectangular strip made of a thin gold layer deposited on a thin insulating layer. Insulating layers can be made of silicon dioxide or silicon nitride. The waveguide's coupling with the source and detector is optimized by adjusting the gap between elements and the thicknesses of the waveguide layers.

The emitted light beam passes through an optical filter and a parabolic mirror, reflecting back through the optical filter and the rear facet of the light source to the QCL structure's active zone. The optical filter's surface plane is rotatable, and the incident light angle is altered by rotating the filter. A galvanomagnetic drive controls the filter rotation, enabling fast and accurate control of the light incident angle.

A spherical mirror made of a monolithic solid-state material has a reflective surface coated with a thin metallic layer for maximum infrared light reflection. The mirror is fixed so that its centre aligns with the optical axis of the system and the centre of the filter plate.

A photonic detector is coupled to the side of the QCL element opposite the rotational angle control mechanism and the spherical mirror. Various types of photonic detectors can be used in specific embodiments, such as a refraction index-sensitive device.

The laser system's functioning stems from the fundamental changes in surface plasmon wave characteristics caused by the interaction between molecular compounds and the waveguide surface. This detection mechanism is more sensitive than optical absorption changes in the same amount of molecular compounds in the air. The present invention addresses the problem of volatile compound detection sensitivity and enhances the reliability of identifying molecular compounds freely flowing in the surrounding atmosphere.

BRIEF DESCRIPTION OF THE DRAWINGS

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:

Fig. 1 shows a schematic representation of an embodiment of the detecting system according to the invention.

Fig. 2(a) and 2(b) shows light emitting source of the quantum cascade laser comprising antireflection element on a first facet of the source and coupled surface plasma wave-guide all fabricated on single semiconductor substrate.

Fig. 3(a) and 3(b) shows an example of schematic arrangement of wave-length variation galvanomagnetic tool in external cavity with boundary set by parabolic mirror in accordance with the embodiment of present invention.

Preferred embodiments of the invention will be described herein below with reference to the drawings. Each figure contains the same numbering for the same or equivalent element.

DETAILED DESCRIPTION OF THE INVENTION

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention.

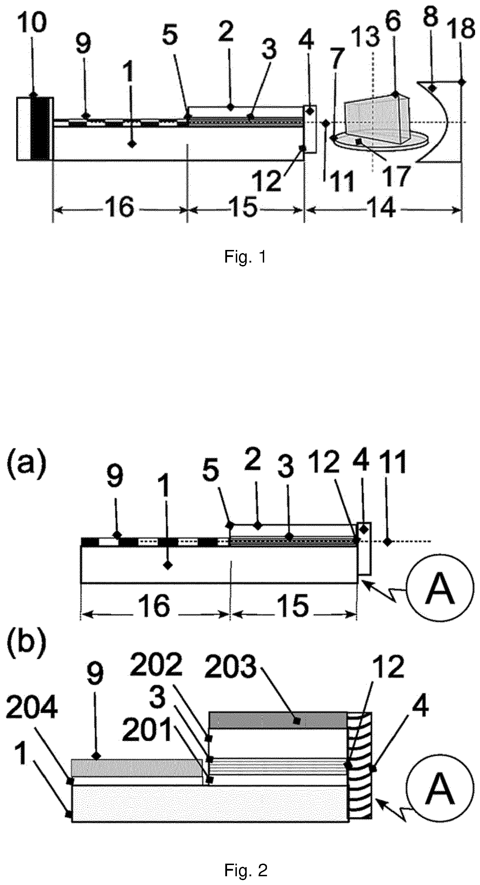

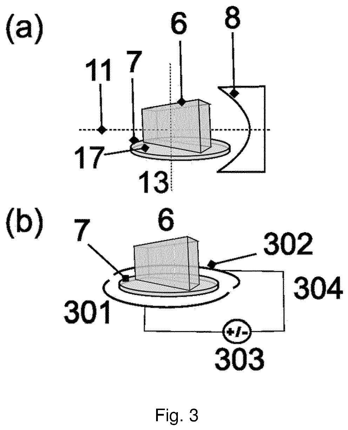

According to the invention, first embodiment of the detection system, is shown in Fig. 1. The detection system comprises a Quantum Cascade Light Emitter (QCLE referring also to Quantum Cascade Laser, QCL) (3) comprising a first semi-reflective facet (5), a second transparent facet (12) with an anti-reflective structure (4), and an electrode (2). The quantum cascade light emitter (3) is monolithically integrated with a plasmonic waveguide (9) on a single substrate (1). The external cavity (14) laser element (15) is designed such that a parabolic mirror (8), positioned at a distance, determined by calibration with respect to the maximum intensity of the QCL emission, from the second transparent facet (12) of the laser along optical axis (11), forms limiting boundary (18) of the external cavity (14). The arrangement includes a flat plate optical filter (6) mounted on a rotational disk (7), ensuring that the optical axis (11) intersects the centre of the flat plate filter (6) at any rotational angle around a vertical axis (13). The flat plate optical filter (6) rotates with respect to the vertical axis (13), perpendicular to flat surface (17) of the rotational disk (7). The rotation of the rotational disk is performed by the galvanomagnetic tool presented in Fig. 3. The detecting system also comprises a coupled photonic detector (10) connected to the plasmonic element (16) comprising the plasmonic wave guide (9) and converting the gas-light interaction into detectable optical feature.

According to the second embodiment of the invention depicted in Fig. 2(a) and 2(b), the detection system comprises a gas-sensitive chip (A) integrated on a single substrate (1) monolithically combining laser element (15) comprising the quantum cascade light emitter (3) with the plasmonic element (16) comprising plasmonic waveguide (9). The quantum cascade light emitter (3) is situated between bottom cladding (201) and top cladding (202), with a top-cap formed electrical contact (203) and electrode (2). The quantum cascade light emitter (3) is an epitaxially grown sequence of A3B5 material structures, which in one embodiment contain indium arsenide and indium antimonide materials. In this embodiment, radiation is emitted at wavelength λ with a line-width Δλ of 20 nm, ranging from 5500 nm to 9500 nm, depending on the combination of indium arsenide and indium antimonide components in the quantum cascade light emitter (3). The second transparent facet (12) of the laser element (15) is modified by a monolithically integrated anti-reflective structure (4), enabling radiation transmission in and out of the laser element (15). Amplified radiation is emitted through the first semi-reflective facet (5). The radiation emitted through the first semi-reflective facet (5) generates a plasmonic wave in plasmonic waveguide (9). The plasmonic waveguide (9) comprising a gold layer of constant thickness is monolithically integrated into the plasmonic element (16) using an insulating interface structure (204). The insulating interface structure (204) provides electrical separation between metal of the plasmonic waveguide (9) and the electrically activated laser element parts (201, 3, 202, 203, 2) and the single substrate (1). In some embodiments, the plasmonic waveguide (9) is partially covered by an insulating film, which is part of the coupling structure between the gas sensitive chip (A) and the photonic detector (not shown in Figs. 2(a) and 2(b) but shown by (10) in Fig. 1) and the elements included in the external cavity (14) in Fig. 1 that produces controlled variation of the emitted radiation by the galvanomagnetic tool shown in Fig. 3. The exposed gold part of the plasmonic waveguide (9) is open to interaction between volatile molecular compounds of the surrounding air and the surface of the plasmonic waveguide (9).

In Figs. 3(a) and 3(b) it is schematically shown a galvanomagnetic tool for external voltage-controlled variation of the emitted radiation in the interval determined by the rotational angle $\varphi$. The galvanomagnetic tool is a part of the external cavity (14) in Fig. 1. The galvanomagnetic tool comprises a flat plate optical filter (6) and a rotational disk (7), designed to rotate horizontally around a vertical axis (13). The flat plate optical filter (6) and the rotational disk (7) are perpendicular to each other. The rotational disk (7) is rotated by a galvanomagnetic drive comprising elements schematically represented by a DC coil (301, 302), a DC power supply (303), and electrical circuit (304), as shown in Fig. 3(b). The rotational angle $\varphi$ is measured as the angle between the optical axis (11) and normal vector to the surface plane of the flat plate optical filter (6). The infrared light beam travelling along the optical axis (11 in Fig. 3(a)) hits the flat plate optical filter (6) surface at an angle equal to the rotational angle $\varphi$. According to Snell's law, the path length of the beam depends on the incident angle $\varphi$ (equal to the rotational angle) as follows:

$$d_L = 2d \cdot \sqrt{1 - \frac{n_1^2}{n_2^2} sin^2 \varphi} \qquad [1]$$

where $d_L$ is the light path length inside the optical filter (6), $d$ is the thickness of the flat plate optical filter (6), refractive index $n_1$ characterizes the surrounding of the filter (6), and $n_2$ is the refractive index of the flat plate optical filter (6). The path length $d_L$ includes the light travelling in both directions, namely forward from the quantum cascade light emitter (3) to the parabolic mirror (8) and in the reverse direction from the parabolic mirror (8) to the quantum cascade light emitter (3). The wavelength of emitted radiation $\lambda k$ is determined by the interference maximum for each produced rotational angle $\varphi$, and this relationship can be described by the following equation:

$$k \cdot \lambda_k = d_L \qquad (2)$$

where $k$ is the interference maximum order equal to an integer from the sequence 0, 1, ... The rotational angle $\varphi$ is changed within a definite interval from 0 to $\pm\varphi_k$ by the galvanomagnetic drive. This rotation produces scanning of the emitted wavelengths in the interval $\lambda \pm \lambda_k$. The mechanism is calibrated in such a way that the applied external voltage $V_{ext}$ is related to the rotational angle $\varphi$ according to a function determined from calibration curve. The accuracy of the rotation mechanism is achieved by selecting the material and thickness of the optical filter plate (6,) making the calibration relationship function adaptable to the required positioning of the rotational disk (7) by the galvanomagnetic drive.

In Fig. 1, the coupled photonic detector (10) is connected to the gas sensitive chip (A in Fig. 2) through hybrid integration methods. The integration scheme is determined by the sensing scheme of the detector (10). In one embodiment, a refractive index sensor is coupled to the gas sensitive chip. In another embodiment, a classical surface plasmon resonance sensor is adapted to the gas sensitive chip. In a third embodiment, a Mach-Zehnder interferometer is adapted to couple with the gas sensitive chip. In a fourth advanced embodiment, a ridge-type semiconductor detector is monolithically integrated with the gas sensitive chip.

Although numerous characteristics and advantages together with structural details and features have been listed in the present description of the invention, the description is provided as an example fulfilment of the invention. Without departing from the principles of the invention, there may be changes in the details, especially in the form, size and layout, in accordance with most widely understood meanings of the concepts and definitions used in claims.

**Claims**

1. A volatile molecular components detection device comprising a semiconductor infrared laser element (15) based on a quantum cascade light emitter (3) **characterised in that** it also comprises a flat plate optical filter (6), a parabolic mirror (8), a plasmonic element (16) comprising a coupled metal-metal oxide thin film plasmonic waveguide (9) and a coupled photonic detector (10).

2. The volatile molecular components detection device according to claim 1, where the laser element (15) comprises a multilayered arrangement of a quantum cascade light emitter (3) for generating light within an infrared wavelength interval, depending on the element's construction and materials, as well as first semi-reflective facet (5), second transparent facet (12) and anti-reflective structure (4).

3. The volatile molecular components detection device according to claim 1 or 2, where the quantum cascade light emitter (3) comprises an extended part of substrate on the antireflecting coating side and a tool comprising of a flat plate optical filter (6) securely fixed to a mechanism for precisely changing the flat plate optical filter (6) surface rotational angle φ concerning the device's optical axis (11) along the quantum cascade light emitter (3) emitted light beam.

4. The volatile molecular components detection device according to claim 3, where the mechanism for precisely changing the flat plate optical filter (6) surface rotational angle φ concerning the device's optical axis (11) along the quantum cascade light emitter (3) emitted light beam comprises a galvanomagnetic drive comprising galvanomagnetic drive elements (301, 302, 303, 304) causing a rotational disk (7) to rotate around the vertical axis (13) turning the disk by limited angle $\varphi$ that is proportional to the external voltage applied to the galvanomagnetic drive elements (301, 302, 303, 304).

5. The volatile molecular components detection device according to claim 1 or 2, where the quantum cascade light emitter (3) comprises a short external cavity closing mirror (8) that reflects the light beam along the optical axis (11) to the quantum cascade light emitter (3), making the wavelength $\lambda$ of the radiation strictly determined by the optical path in the flat plate optical filter (6), depending on the rotational angle $\varphi$ around the vertical axis (13).

6. The volatile molecular components detection device according to claim 5, where the mirror (8) comprises of a substrate, a single pure metal coating, and several specially structured thin metal oxide films, depending on the selected wavelength $\lambda$, laser modes, and light beam control tools, where the parabolic mirror's (8) focus length ($F_L$) is such which optimises laser power and beam divergence.

7. The volatile molecular components detection device according to claim 1 or 2, where the quantum cascade light emitter (3) is physically coupled with a planar plasmonic waveguide (9), aligned with the laser element's optical axis (11).

8. The volatile molecular components detection device according to claim 7, where the plasmonic waveguide (9) comprises a gold film that in an example embodiment can be shaped as planar rectangular strip with exposed gold surfaces accessible to the surrounding volatile molecular atmosphere.

9. The volatile molecular components detection device according to claim 8, where the plasmonic waveguide (9) comprises a gold film that in an example embodiment can be shaped as planar rectangular strip and is covered with insulating silicon oxide and silicon nitride coatings.

10. The volatile molecular components detection device according to any one of claims 7-9, where the waveguide is integrated with a coupled photonic detector (10) for converting changes in plasmonic wave parameters into electrical signals transmitted to an external circuit.

Fig. 1

Fig. 2

Fig. 3

Europäisches
Patentamt
European
Patent Office
Office européen
des brevets

# EUROPEAN SEARCH REPORT

Application Number

EP 23 19 3638

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SCHWARZ BENEDIKT ET AL: "Monolithically integrated mid-infrared lab-on-a-chip using plasmonics and quantum cascade structures", NATURE COMMUNICATIONS, [Online] vol. 5, no. 1, 6 June 2014 (2014-06-06), XP093123171, UK ISSN: 2041-1723, DOI: 10.1038/ncomms5085 Retrieved from the Internet: URL:http://www.nature.com/articles/ncomms5085> [retrieved on 2024-01-24] * Figs. 1-3 captions; page 2, col 1, paragraph 4 – page 2, col 2, paragraph 1; figures 1-3 * | 1-10 | INV. G01N21/39 G01N21/552 G01N21/3504 G01N21/3577 H01S5/30 |
| A | RISTANIC DANIELA ET AL: "Monolithically integrated mid-infrared sensor using narrow mode operation and temperature feedback", APPLIED PHYSICS LETTERS, [Online] vol. 106, no. 4, 26 January 2015 (2015-01-26), XP093123186, 2 Huntington Quadrangle, Melville, NY 11747 ISSN: 0003-6951, DOI: 10.1063/1.4906802 Retrieved from the Internet: URL:http://scitation.aip.org/deliver/fulltext/aip/journal/apl/106/4/1.4906802.pdf?itemId=/content/aip/journal/apl/106/4/10.1063/1.4906802&mimeType=pdf&containerItemId=content/aip/journal/apl> [retrieved on 2024-01-24] * page 1, col 1, paragraph 2 * | 1-10 | |

TECHNICAL FIELDS SEARCHED (IPC)

G01N
H01S

-/--

The present search report has been drawn up for all claims

| Place of search | Date of completion of the search | Examiner |
|---|---|---|
| Munich | 31 January 2024 | Mason, William |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALBERTI SEBASTIÁN ET AL: "Integrated Nanophotonic Waveguide-Based Devices for IR and Raman Gas Spectroscopy", SENSORS, vol. 21, no. 21, 30 October 2021 (2021-10-30), page 7224, XP093051370, DOI: 10.3390/s21217224 * page 1, paragraph 1; figure 2(b) * | 1-10 | |
| A | US 2020/141866 A1 (GERWERT KLAUS [DE]) 7 May 2020 (2020-05-07) * [0141]; claim 1; figure 18 * | 1-10 | |
| A | US 2010/002739 A1 (HU QING [US] ET AL) 7 January 2010 (2010-01-07) * [0068]-[0069], [0073]; figure 7A * | 1-10 | |
| A | BO MENG ET AL: "Broadly tunable single-mode mid-infrared quantum cascade lasers", JOURNAL OF OPTICS, INSTITUTE OF PHYSICS PUBLISHING, BRISTOL GB, vol. 17, no. 2, 30 January 2015 (2015-01-30), page 23001, XP020278868, ISSN: 2040-8986, DOI: 10.1088/2040-8978/17/2/023001 [retrieved on 2015-01-30] * figure 4(a) * | 1-10 | |
| A,D | US 7 733 924 B2 (UNIV RICE WILLIAM M [US]) 8 June 2010 (2010-06-08) * figure 1 * | 1-10 | |

TECHNICAL FIELDS
SEARCHED (IPC)

-/--

The present search report has been drawn up for all claims

| Place of search | Date of completion of the search | Examiner |
|---|---|---|
| Munich | 31 January 2024 | Mason, William |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

**Application Number**

**EP 23 19 3638**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RISTANIC DANIELA ET AL: "Monolithic absorption sensors based on Bi-functional quantum cascade structures", 2015 CONFERENCE ON LASERS AND ELECTRO-OPTICS (CLEO), OSA, 10 May 2015 (2015-05-10), pages 1-2, XP033194217, [retrieved on 2015-08-10] * section 2; figure 1 * | 1-10 | |
| A | HINKOV BORISLAV ET AL: "Mid-IR Plasmonics for Monolithic Photonic Integrated Circuits", 2022 EUROPEAN CONFERENCE ON OPTICAL COMMUNICATION (ECOC), OPTICA, 18 September 2022 (2022-09-18), pages 1-4, XP034251994, [retrieved on 2022-12-20] * figure 1 * | 1-10 | |
| A | BOUSSEKSOU A ET AL: "Mid-infrared field concentration of electrically generated surface plasmons polaritons", QUANTUM SENSING AND NANOPHOTONIC DEVICES IX, SPIE, 1000 20TH ST. BELLINGHAM WA 98225-6705 USA, vol. 8268, no. 1, 21 January 2012 (2012-01-21), pages 1-7, XP060000883, DOI: 10.1117/12.906738 [retrieved on 2012-01-20] * figures 1-2 * | 1-10 | **TECHNICAL FIELDS SEARCHED (IPC)** |

The present search report has been drawn up for all claims

| Place of search | Date of completion of the search | Examiner |
|---|---|---|
| Munich | 31 January 2024 | Mason, William |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 3 of 3

**EP 4 517 302 A1**

## ANNEX TO THE EUROPEAN SEARCH REPORT
## ON EUROPEAN PATENT APPLICATION NO.

EP 23 19 3638

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2024

| Patent document cited in search report | | Publication date | Patent family member(s) | | Publication date |
|---|---|---|---|---|---|
| US 2020141866 | A1 | 07-05-2020 | EP | 3631446 A1 | 08-04-2020 |
| | | | US | 2020141866 A1 | 07-05-2020 |
| | | | WO | 2018219969 A1 | 06-12-2018 |
| US 2010002739 | A1 | 07-01-2010 | US | 2010002739 A1 | 07-01-2010 |
| | | | WO | 2010011392 A2 | 28-01-2010 |
| US 7733924 | B2 | 08-06-2010 | NONE | | |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 11075315 B
- US 6970484 B
- US 7733924 B
- US 8351474 B
- US 6556599 B
- US 10348053 B